# EUROPEAN PATENT SPECIFICATION

(11) **EP 2 230 693 B1**
(45) Date of publication and mention of the grant of the patent: **04.01.2012**
(21) Application number: 10003020.4
(22) Date of filing: 06.09.2005
(51) Int. Cl.: H01L 31/0264, H01L 31/0272, H01L 31/04

(54) **Formation of solar cells on foil substrates**
Bildung von Solarzellen auf Foliensubstraten
Formation de cellules solaires sur des substrats en forme de feuille

(30) Priority: 18.09.2004 US 943685; 18.09.2004 US 943658
(43) Date of publication of application: 22.09.2010
(62) Divisional of application: 05796064.3
(73) Proprietor: Nanosolar Inc., San Jose, CA 95138-1017 (US)
(72) Inventor: Leidholm, Craig R., San Jose, CA 95138 (US); Bollmann, Brent, San Jose, CA 95138 (US)
(74) Representative: Boyce, Conor

(56) References cited:
- EP-A- 1 665 390
- EP-A- 1 747 590
- US-A- 5 578 503
- US-B2- 6 518 086

## Description

### FIELD OF THE INVENTION

The present invention relates to fabrication of photovoltaic devices and more specifically to processing and annealing of absorber layers for photovoltaic devices.

### BACKGROUND OF THE INVENTION

Efficient photovoltaic devices, such as solar cells, have been fabricated using absorber layers made with alloys containing elements of group IB, IIIA and VIA, e.g., alloys of copper with indium and/or gallium or aluminum and selenium and/or sulfur. Such absorber layers are often referred to as CIGS layers and the resulting devices are often referred to as CIGS solar cells. The CIGS absorber layer may be deposited on a substrate. It would be desirable to fabricate such an absorber layer on an aluminum foil substrate because Aluminum foil is relatively inexpensive, lightweight, and flexible. Unfortunately, current techniques for depositing CIGS absorber layers are incompatible with the use of aluminum foil as a substrate.

Typical deposition techniques include evaporation, sputtering, chemical vapor deposition, and the like. These deposition processes are typically carried out at high temperatures and for extended times. Both factors can result in damage to the substrate upon which deposition is occurring. Such damage can arise directly from changes in the substrate material upon exposure to heat, and/or from undesirable chemical reactions driven by the heat of the deposition process. Thus very robust substrate materials are typically required for fabrication of CIGS solar cells. These limitations have excluded the use of aluminum and aluminum-foil based foils.

An alternative deposition approach is the solution-based printing of the CIGS precursor materials onto a substrate. Examples of solution-based printing techniques are described, e.g., in Published PCT Application WO 2002/084708 and commonly-assigned U.S. Patent Application 10/782,017, both of which are incorporated herein by reference. Advantages to this deposition approach include both the relatively lower deposition temperature and the rapidity of the deposition process. Both advantages serve to minimize the potential for heat-induced damage of the substrate on which the deposit is being formed. Documents US 6 518 086 B and US 5 578 503 A describe methods to manufacture CIGS-type solar cells.

Although solution deposition is a relatively low temperature step in fabrication of CIGS solar cells, it is not the only step. In addition to the deposition, a key step in the fabrication of CIGS solar cells is the selenization and annealing of the CIGS absorber layer. Selenization introduces selenium into the bulk CIG or CI absorber layer, where the element incorporates into the film, while the annealing provides the absorber layer with the proper crystalline structure. In the prior art, selenization and annealing has been performed by heating the substrate in the presence of H₂Se or Se vapor and keeping this nascent absorber layer at high temperatures for long periods of time.

While use of A1 as a substrate for solar cell devices would be desirable due to both the low cost and lightweight nature of such a substrate, conventional techniques that effectively anneal the CIGS absorber layer also heat the substrate to high temperatures, resulting in damage to A1 substrates. There are several factors that result in A1 substrate degradation upon extended exposure to heat and/or selenium-containing compounds for extended times. First, upon extended heating, the discrete layers within a Mo-coated A1 substrate can fuse and form an intermetallic back contact for the device, which decreases the intended electronic functionality of the Mo-layer. Second, the interfacial morphology of the Mo layer is altered during heating, which can negatively affect subsequent CIGS grain growth through changes in the nucleation patterns that arise on the Mo layer surface. Third, upon extended heating, A1 can migrate into the CIGS absorber layer, disrupting the function of the semiconductor. Fourth, the impurities that are typically present in the A1 foil (e.g. Si, Fe, Mn, Ti, Zn, and V) can travel along with mobile A1 that diffuses into the solar cell upon extended heating, which can disrupt both the electronic and optoelectronic function of the cell. Fifth, when Se is exposed to A1 for relatively long times and at relatively high temperatures, aluminum selenide can form, which is unstable. In moist air the aluminum selenide can react with water vapor to form aluminum oxide and hydrogen selenide. Hydrogen selenide is a highly toxic gas, whose free formation can pose a safety hazard. For all these reasons, high-temperature deposition, annealing, and selenization are therefore impractical for substrates made of aluminum or aluminum alloys.

Because of the high-temperature, long-duration deposition and annealing steps, CIGS solar cells cannot be effectively fabricated on aluminum substrates (e.g. flexible foils comprised of A1 and/or A1-based alloys) and instead must be fabricated on heavier substrates made of more robust (and more expensive) materials, such as stainless steel, titanium, or molybdenum foils, glass substrates, or metal- or metal-oxide coated glass. Thus, even though CIGS solar cells based on aluminum foils would be more lightweight, flexible, and inexpensive than stainless steel, titanium, or molybdenum foils, glass substrates, or metal- or metal-oxide coated glass substrates, current practice does not permit aluminum foil to be used as a substrate.

Thus, there is a need in the art, for a method for fabricating CIGS solar cells on aluminum substrates.

### BRIEF DESCRIPTION OF THE DRAWINGS

The teachings of the present invention can be readily understood by considering the following detailed description in conjunction with the accompanying drawings, in which:

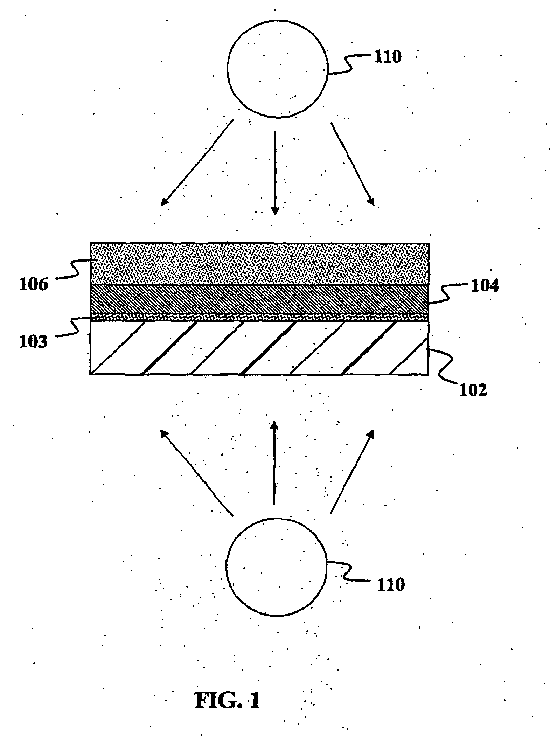

FIG. 1 is a cross-sectional schematic diagram illustrating fabrication of an absorber layer according to an embodiment of the present invention.

### DESCRIPTION OF THE SPECIFIC EMBODIMENTS

Although the following detailed description contains many specific details for the purposes of illustration, anyone of ordinary skill in the art will appreciate that many variations and alterations to the following details are within the scope of the invention. Accordingly, the exemplary embodiments of the invention described below are set forth without any loss of generality to, and without imposing limitations upon, the claimed invention.

Embodiments of the present invention allow fabrication of CIGS absorber layers on aluminum foil substrates. According to embodiments of the present invention, a method to form an absorber layer of a photovoltaic device is recited in claim 1. Further advantageous embodiments are recited in claims 2-14.

FIG. 1 depicts a partially fabricated photovoltaic device **100**, and a rapid heating unit **110** the device generally includes an aluminum foil substrate **102**, an optional base electrode **104**, and a nascent absorber layer **106**. The aluminum foil substrate **102** may be approximately 5 microns to one hundred or more microns thick and of any suitable width and length. The aluminum foil substrate **102** may be made of aluminum or an aluminum-based alloy. Alternatively, the aluminum foil substrate **102** may be made by metallizing a polymer foil substrate, where the polymer is selected from the group of polyesters, polyethylene naphtalates, polyetherimides, polyethersulfones, polyetheretherketones, polyimides, and/or combinations of the above. By way of example, the substrate **102** may be in the form of a long sheet of aluminum foil suitable for processing in a roll-to-roll system. The base electrode **104** is made of an electrically conducive material compatible with processing of the nascent absorber layer **106**. By way of example, the base electrode **104** may be a layer of molybdenum, e.g., about 0.1 to 25 microns thick, and more preferably from about 0.1 to 5 microns thick. The base electrode layer may be deposited by sputtering or evaporation or, alternatively, by chemical vapor deposition (CVD), atomic layer deposition (ALD), sol-gel coating, electroplating and the like.

Aluminum and molybdenum can and often do inter-diffuse into one another, with deleterious electronic and/or optoelectronic effects on the device **100**. To inhibit such inter-diffusion, an intermediate, interfacial layer **103** may be incorporated between the aluminum foil substrate **102** and molybdenum base electrode **104**. The interfacial layer may be composed of any of a variety of materials, including but not limited to chromium, vanadium, tungsten, and glass, or compounds such as nitrides (including tantalum nitride, tungsten nitride, and silicon nitride), oxides, and/or carbides. The thickness of this layer can range from 10 nm to 50 nm, and more preferably from 10 nm to 30 nm.

The nascent absorber layer **106** may include material containing elements of groups IB, IIIA, and (optionally) VIA. Preferably, the absorber layer copper (Cu) is the group IB element, Gallium (Ga) and/or Indium (In) and/or Aluminum may be the group IIIA elements and Selenium (Se) and/or Sulfur (S) as group VIA elements. The group VIA element may be incorporated into the nascent absorber layer **106** when it is initially solution deposited or during subsequent processing to form a final absorber layer from the nascent absorber layer **106**. The nascent absorber layer **106** may be about 1000 nm thick when deposited. Subsequent rapid thermal processing and incorporation of group VIA elements may change the morphology of the resulting absorber layer such that it increases in thickness (e.g., to about twice as much as the nascent layer thickness under some circumstances).

Fabrication of the absorber layer on the aluminum foil substrate **102** is relatively straightforward. First, the nascent absorber layer is deposited on the substrate **102** either directly on the aluminum or on an uppermost layer such as the electrode **104**. By way of example, and without loss of generality, the nascent absorber layer may be deposited in the form of a film of a solution-based precursor material containing nanoparticles that include one or more elements of groups IB, IIIA and (optionally) VIA. Examples of such films of such solution-based printing techniques are described e.g., in commonly-assigned U.S. Patent Application 10/782,017, entitled "SOLUTION-BASED FABRICATION OF PHOTOVOLTAIC CELL" and also in PCT Publication WO 02/084708, entitled "METHOD OF FORMING SEMICONDUCTOR COMPOUND FILM FOR FABRICATION OF ELECTRONIC DEVICE AND FILM PRODUCED BY SAME" the disclosures of both of which are incorporated herein by reference.

Alternatively, the nascent absorber layer 106 may be formed by a sequence of atomic layer deposition reactions or any other conventional process normally used for forming such layers. Atomic layer deposition of IB-IIIA-VIA absorber layers is described, e.g., in commonly-assigned, co-pending application serial no. 10/943,658, entitled "FORMATION OF CIGS ABSORBER LAYER MATERIALS USING ATOMIC LAYER DEPOSITION AND HIGH THROUGHPUT SURFACE TREATMENT ON COILED FLEXIBLE SUBSTRATES", which has been incorporated herein by reference above.

The nascent absorber layer **106** is then annealed by flash heating it and/or the substrate **102** from an ambient temperature to an average plateau temperature range of between about 200°C and about 600°C with the heating unit **110**. The heating unit **110** preferably provides sufficient heat to rapidly raise the temperature of the nascent absorber layer **106** and/or substrate **102** (or a significant portion thereof) e.g., at between about 5 C°/see and about 150 C°/s. By way of example, the heating unit **110** may include one or more infrared (IR) lamps that provide sufficient radiant heat. By way of example, 8 IR lamps rated at about 500 watts each situated about 3.175 mm (1/8") to about 25.4 mm (1") from the surface of the substrate **102** (4 above and 4 below the substrate, all aimed towards the substrate) can provide sufficient radiant heat to process a substrate area of about 25 cm² per hour in a 11 mm (4") tube furnace. The lamps may be ramped up in a controlled fashion, e.g., at an average ramp rate of about 10 C°/s. Those of skill in the art will be able to devise other types and configurations of heat sources that may be used as the heating unit **110**. For example, in a roll-to-roll manufacturing line, heating and other processing can be carried out by use of IR lamps spaced 25.4 mm (1") apart along the length of the processing region, with IR lamps equally positioned both above and below the substrate, and where both the IR lamps above and below the substrate are aimed towards the substrate. Alternatively, IR lamps could be placed either only above or only below the substrate **102**, and/or in configurations that augment lateral heating from the side of the chamber to the side of the substrate **102**.

The absorber layer **106** and/or substrate **102** are maintained in the average plateau temperature range for between about 2 minutes and about 30 minutes. For example, the temperature may be maintained in the desired range by reducing the amount of heat from the heating unit **110** to a suitable level. In the example of IR lamps, the heat may be reduced by simply turning off the lamps. Alternatively, the lamps may be actively cooled. The temperature of the absorber layer **106** and/or substrate **102** is subsequently reduced to a suitable level, e.g., by further reducing or shutting off the supply of heat from the heating unit **110**.

In some embodiments of the invention, group VIA elements such as selenium or sulfur may be incorporated into the absorber layer either before or during the annealing stage. Alternatively, two or more discrete or continuous annealing stages can be sequentially carried out, in which group VIA elements such as selenium or sulfur are incorporated in a second or latter stage. For example, the nascent absorber layer 106 may be exposed to H₂Se gas, H₂S gas or Se vapor before or during flash heating or rapid thermal processing (RTP). In this embodiment, the relative brevity of exposure allows the aluminum substrate to better withstand the presence of these gases and vapors, especially at high heat levels.

Once the nascent absorber layer **106** has been annealed additional layers may be formed to complete the device **100**. For example a window layer is typically used as a junction partner for the absorber layer. By way of example, the junction partner layer may include cadmium sulfide (CdS), zinc sulfide (ZnS), or zinc selenide (ZnSe) or some combination of two or more of these. Layers of these materials may be deposited, e.g., by chemical bath deposition, chemical surface deposition, or spray pyrolysis, to a thickness of about 50 nm to about 100 nm. In addition, a transparent electrode, e.g., a conductive oxide layer, may be formed on the window layer by sputtering, vapor deposition, CVD, ALD, electrochemical atomic layer epitaxy and the like.

Embodiments of the present invention overcome the disadvantages associated with the prior art by rapid thermal processing of nascent CIGS absorber layers deposited or otherwise formed on aluminum substrates. Aluminum substrates are much cheaper and more lightweight than conventional substrates. Thus, solar cells based on aluminum substrates can have a lower cost per watt for electricity generated and a far shorter energy payback period when compared to conventional silicon-based solar cells. Furthermore aluminum substrates allow for a flexible form factor that permits both high-throughput roll-to-roll printing during solar cell fabrication and faster and easier installation processes during solar module and system installation.

Embodiments of the present invention allow the fabrication of lightweight and inexpensive photovoltaic devices on aluminum substrates. Flash heating / rapid thermal processing of the nascent absorber layer 106 allows for proper annealing and incorporation of group VIA elements without damaging or destroying the aluminum foil substrate 102. The plateau temperature range is sufficiently below the melting point of aluminum (about 660°C) to avoid damaging or destroying the aluminum foil substrate. The use of aluminum foil substrates can greatly reduce the materials cost of photovoltaic devices, e.g., solar cells, made on such substrates thereby reducing the cost per watt. Economies of scale may be achieved by processing the aluminum foil substrate in a roll-to-roll fashion, with the various layers of the photovoltaic devices being built up on the substrate as it passes through a series of deposition annealing and other processing stages.

While the above is a complete description of the preferred embodiment of the present invention, it is possible to use various alternatives, modifications and equivalents. Therefore, the scope of the present invention should be determined not with reference to the above description but should, instead, be determined with reference to the appended claims. In the claims that follow, the indefinite article "A", or "An" refers to a quantity of one or more of the item following the article, except where expressly stated otherwise.

## Claims

1. A method for forming an absorber layer of a CIGS photovoltaic device (100), comprising the steps of:
forming a nascent absorber layer (106) on a metal foil substrate (102);
using a roll-to-roll system to transport the substrate through a furnace;
heating the nascent absorber layer and/or substrate at a distance of 3.175 mm (1/8") to 25.4 mm (1") from a surface of the nascent absorber layer and/or substrate in the furnace and in an H₂Se gas, H₂S gas, or group VIA vapor.

2. The method of claim 1 wherein forming the nascent absorber layer includes depositing the nascent absorber layer from a solution of nanoparticulate precursor materials.

3. The method of claim 1 comprising: heating the nascent absorber layer and/or substrate from an ambient temperature to a plateau temperature range of between 200°C and 600°C; maintaining the absorber layer and/or substrate in the plateau temperature range for between 2 minutes and 30 minutes; and reducing the temperature of the absorber layer and/or substrate.

4. The method of claim 3 comprising rapidly heating the nascent absorber layer and/or substrate including increasing the temperature of the absorber layer and/or substrate at a rate of between 5 °C/s and 150°C/s.

5. The method of claim 3 further comprising, incorporating one or more group VIA elements into the nascent absorber layer before the step of rapidly heating the nascent absorber layer and/or substrate.

6. The method of claim 3 wherein the one or more group VIA elements include one of selenium or sulfur.

7. The method of claim 3 comprising rapidly heating the nascent absorber layer and/or substrate by radiant heating of the nascent absorber layer and/or substrate.

8. The method of claim 7 comprising applying the radiant heating with one or more infrared lamps (110).

9. The method of claim 3 further comprising, incorporating one or more group VIA elements into the nascent absorber layer after rapidly heating the nascent absorber layer and/or substrate.

10. The method of claim 3 wherein the metal foil substrate comprises an aluminum substrate.

11. The method of claim 3, further comprising, incorporating an intermediate layer (103) between a layer of molybdenum (104) and the metal foil substrate (102), wherein the intermediate layer inhibits inter-diffusion of molybdenum and the metal foil substrate during heating.

12. The method of claim 11 wherein, the intermediate layer includes, chromium, vanadium, tungsten, glass, and/or nitrides, tantalum nitride, tungsten nitride, and silicon nitride, oxides, or carbides.

13. The method of claim 1 wherein forming a nascent absorber layer includes depositing a film of an ink containing elements of groups IB and IIIA on the metal foil substrate.

14. The method of claim 1, further comprising disposing a layer of molybdenum (104) between the metal foil substrate (102) and the nascent absorber layer (106).

## Patentansprüche

1. Verfahren zum Bilden einer Absorberschicht eines photovoltaischen CIGS-Bauelements (100), das die folgenden Schritte beinhaltet:
Bilden einer naszierenden Absorberschicht (106) auf einem Metallfoliensubstrat (102);
Verwenden eines Rolle-zu-Rolle-Systems zum Transportieren des Substrats durch einen Ofen;
Erhitzen der naszierenden Absorberschicht und/oder des Substrats in einem Abstand von 3,175 mm (1/8 Zoll) bis 25,4 mm (1 Zoll) von einer Oberfläche der naszierenden Absorberschicht und/oder des Substrats in dem Ofen und in einem H₂Se-Gas, H₂S-Gas oder einem Dampf der Gruppe VIA.

2. Verfahren nach Anspruch 1, wobei das Bilden der naszierenden Absorberschicht das Auftragen der naszierenden Absorberschicht von einer Lösung aus nanopartikulären Vorläufermaterialien beinhaltet.

3. Verfahren nach Anspruch 1, das Folgendes beinhaltet:
Erhitzen der naszierenden Absorberschicht und/oder des Substrats von einer Umgebungstemperatur auf einen Plateautemperaturbereich zwischen 200°C und 600°C;
Halten der Absorberschicht und/oder des Substrats für einen Zeitraum zwischen 2 Minuten und 30 Minuten in dem Plateautemperaturbereich; und
Reduzieren der Temperatur der Absorberschicht und/oder des Substrats.

4. Verfahren nach Anspruch 3, das das rasche Erhitzen der naszierenden Absorberschicht und/oder des Substrats einschließlich des Erhöhens der Temperatur der Absorberschicht und/oder des Substrats mit einer Rate zwischen 5°C/s und 150°C/s beinhaltet.

5. Verfahren nach Anspruch 3, das ferner das Einbauen von einem oder mehreren Elementen der Gruppe VIA in die naszierende Absorberschicht vor dem Schritt des raschen Erhitzens der naszierenden Absorberschicht und/oder des Substrats beinhaltet.

6. Verfahren nach Anspruch 3, wobei die ein oder mehreren Elemente der Gruppe VIA Selen oder Schwefel beinhalten.

7. Verfahren nach Anspruch 3, das das rasche Erhitzen der naszierenden Absorberschicht und/oder des Substrats durch Strahlungserhitzung der naszierenden Absorberschicht und/oder des Substrats beinhaltet.

8. Verfahren nach Anspruch 7, das das Anwenden der Strahlungserhitzung mit einer oder mehreren Infrarotlampen (110) beinhaltet.

9. Verfahren nach Anspruch 3, das ferner das Einbauen von einem oder mehreren Elementen der Gruppe VIA in die naszierende Absorberschicht nach dem raschen Erhitzen der naszierenden Absorberschicht und/oder des Substrats beinhaltet.

10. Verfahren nach Anspruch 3, wobei das Metallfoliensubstrat ein Aluminiumsubstrat beinhaltet.

11. Verfahren nach Anspruch 3, das ferner das Einbauen einer Zwischenschicht (103) zwischen eine Molybdänschicht (104) und das Metallfoliensubstrat (102) beinhaltet, wobei die Zwischenschicht eine Interdiffusion von Molybdän und dem Metallfoliensubstrat während des Erhitzens hemmt.

12. Verfahren nach Anspruch 11, wobei die Zwischenschicht Chrom, Vanadium, Wolfram, Glas und/oder Nitride, Tantalnitrid, Wolframnitrid und Siliciumnitrid, Oxide oder Carbide beinhaltet.

13. Verfahren nach Anspruch 1, wobei das Bilden einer naszierenden Absorberschicht das Auftragen eines Films einer Farbe beinhaltet, die Elemente der Gruppen IB und IIIA auf dem Metallfoliensubstrat beinhaltet.

14. Verfahren nach Anspruch 1, das ferner das Anordnen einer Molybdänschicht (104) zwischen dem Metallfoliensubstrat (102) und der naszierenden Absorberschicht (106) beinhaltet.

## Revendications

1. Procédé de formation d'une couche absorbante d'un dispositif photovoltaïque CIGS (100), comprenant les étapes suivantes :
formation d'une couche absorbante naissante (106) sur un substrat de feuille métallique (102);
utilisation d'un système de rouleau à rouleau pour transporter le substrat dans un four;
le chauffage de la couche absorbante naissante et/ou du substrat à une distance de 3,175 mm (1/8^{e} de pouce) à 25,4 mm (1 pouce) d'une surface de la couche absorbante naissante et/ou du substrat dans le four et dans un gaz de H₂Se, un gaz H₂S ou une vapeur du groupe VIA.

2. Procédé selon la revendication 1, dans lequel la formation de la couche absorbante naissante comporte le dépôt de la couche absorbante naissante à partir d'une solution de matériaux précurseurs à nanoparticules.

3. Procédé selon la revendication 1 comprenant : le chauffage de la couche absorbante naissante et/ou du substrat d'une température ambiante à une plage de températures plateau entre 200°C et 600°C; le maintien de la couche absorbante et/ou du substrat dans la plage de températures plateau entre 2 minutes et 30 minutes, et la réduction de la température de la couche absorbante et/ou du substrat.

4. Procédé selon la revendication 3, comprenant le chauffage rapide de la couche absorbante naissante et/ou du substrat y compris l'augmentation de la température de la couche absorbante et/ou du substrat à un taux entre 5 °C/s et 150 °C/s.

5. Procédé selon la revendication 3, comprenant en outre l'incorporation d'un ou de plusieurs éléments du groupe VIA dans la couche absorbante naissante avant l'étape de chauffage rapide de la couche absorbante naissante et/ou du substrat.

6. Procédé selon la revendication 3, dans lequel les un ou plusieurs éléments du groupe VIA comportent l'un de sélénium ou de soufre.

7. Procédé selon la revendication 3, comprenant le chauffage rapide de la couche absorbante naissante et/ou du substrat par un chauffage rayonnant de la couche absorbante naissante et/ou du substrat.

8. Procédé selon la revendication 7, comprenant l'application du chauffage rayonnant avec une ou plusieurs lampes à infrarouges (110).

9. Procédé selon la revendication 3, comprenant en outre l'incorporation d'un ou de plusieurs éléments du groupe VIA dans la couche absorbante naissante après le chauffage rapide de la couche absorbante naissante et/ou du substrat.

10. Procédé selon la revendication 3, dans lequel le substrat en feuille métallique comprend un substrat d'aluminium.

11. Procédé selon la revendication 3, comprenant en outre : l'incorporation d'une couche intermédiaire (103) entre une couche de molybdène (104) et le substrat en feuille métallique (102), dans lequel la couche intermédiaire inhibe l'inter-diffusion de molybdène et du substrat en feuille métallique durant le chauffage.

12. Procédé selon la revendication 11, dans lequel la couche intermédiaire comporte du chrome, du vanadium, du tungstène, du verre, et/ou des nitrures, du nitrure de tantale, du nitrure de tungstène, et du nitrure de silicium, des oxydes ou des carbures.

13. Procédé selon la revendication 1, dans lequel la formation d'une couche absorbante naissante comporte le dépôt d'un film d'une encre contenant des éléments des groupes IB et IIIA sur le substrat en feuille métallique.

14. Procédé selon la revendication 1, comprenant en outre le dépôt d'une couche de molybdène (104) entre le substrat en feuille métallique (102) et la couche absorbante naissante (106).
